Europäisches Patentamt

European Patent Office

Office européen des brevets

(11) Publication number: **0 665 651 A2**

## EUROPEAN PATENT APPLICATION

(21) Application number: 95300129.4

(51) Int. Cl.⁶: **H03L 7/197**

(22) Date of filing: **10.01.95**

(30) Priority: **31.01.94 US 189521**

(43) Date of publication of application:
**02.08.95 Bulletin 95/31**

(84) Designated Contracting States:
**DE FR GB IT**

(71) Applicant: **HEWLETT-PACKARD COMPANY**
**3000 Hanover Street**
**Palo Alto,**
**California 94304-1181 (US)**

(72) Inventor: **Davidson, Mark N.**
**2307 Floral Way**
**Santa Rosa, CA 95403 (US)**
Inventor: **Hillstrom, Timothy L.**
**11506-21st Place NE**
**Lake Stevens, WA 98258 (US)**

(74) Representative: **Colgan, Stephen James et al**
**CARPMAELS & RANSFORD**
**43 Bloomsbury Square**
**London WC1A 2RA (GB)**

(54) **Phased locked loop synthesizer using a digital rate multiplier reference circuit.**

(57) A phase locked loop synthesizer (20) for generating a digitally programmable, continuous wave signal comprises a rate multiplier (26) and divider (28) connected in a reference signal path to a phase detector ( 42). The rate multiplier and divider generate a reference signal which is programmable to any of a set of regularly spaced frequencies having exact decimal representations. The divider limits the peak-to-peak phase deviation of the rate multiplier. The phase detector locks a synthesized signal generated by a variable frequency oscillator (44) to the phase of the programmed reference signal. A spur filter (60) connected to the phase detector output (46) reduces spurious frequencies in the phase detector output.

## FIG. 1

FIELD OF THE INVENTION

The present invention relates to phase locked loop synthesis of a programmable frequency continuous wave signal, and more particularly relates to generating such a continuous wave signal having very low phase noise and very small spurious sidebands.

BACKGROUND AND SUMMARY OF THE INVENTION

In electronic measurement instruments and in communications devices, among other applications, it is useful to generate a continuous wave signal, and to program the frequency of the signal. In general, a continuous wave signal is an electrical signal having a constant, unmodulated frequency (the "carrier frequency").

Frequency synthesizers utilizing a phase locked loop (PLL) to generate a continuous wave signal at a precise and stable frequency are known in the art. Typically, a PLL includes a tunable oscillator such as a voltage controlled oscillator (VCO), the output of which is locked to a known reference signal by means of a phase detector. The phase detector generates an output voltage or current that is related to the phase difference between the reference signal and the VCO output signal. The output of the phase detector is coupled back to the input of the VCO in a feedback loop to tune and lock the VCO to a desired frequency. This forces the VCO output signal to have the same phase and frequency as the reference signal.

To generate a continuous wave signal having a programmable frequency, a programmable divider can be interposed in the feedback loop between the VCO output and the phase detector of the PLL. The programmable divider divides the carrier frequency of the VCO output signal by a selectable divisor before it is compared with the reference frequency in the phase detector. (The selectable divisor can be either an integer or fractional value.) Accordingly, by programming the value of the divisor, the VCO output signal's frequency can be made equal to a desired multiple of the reference frequency.

A disadvantage of this PLL synthesizer is that the presence of the programmable divider in the feedback path also multiplies any noise from the reference frequency signal and phase detector by the same divisor. This multiplied noise appears in the output signal as phase noise sidebands at frequencies offset from the carrier frequency by less than the bandwidth of the PLL. The PLL bandwidth can be reduced so as to reduce the phase noise sidebands. However, reduction of the PLL bandwidth comes at a cost of also degrading proportionately the time required to switch the output signal's carrier frequency between programmed frequencies. Accordingly, such prior PLL synthesizers with a feedback path divider cannot simultaneously achieve low phase noise and fast carrier frequency switching.

Digitally programmable continuous wave signals also can be generated with a PLL synthesizer having a programmable divider in a reference signal path. In this configuration, the digital divider proportionately reduces the reference signal frequency by the programmed divisor, and the phase detector locks the VCO output signal to that reduced reference frequency. By selecting an appropriate value for the divisor, the VCO output signal frequency can be made equal to a desired fraction of the reference signal frequency. More specifically, for a selected divisor value, N, the VCO output signal frequency is proportional to the reference signal frequency multiplied by 1/N. Additionally, PLL synthesizers can have programmable dividers in both the reference signal path and the feedack path to produce a VCO output signal frequency proportional to some rational fraction M/N times the reference frequency, where M is the divisor of the feedback path divider, and N is the divisor of the reference signal path divider.

A disadvantage to PLL synthesizers with a reference path divider is that the programmed frequencies they generate are not regularly spaced. Also, the programmed frequencies they generate do not, in general, have exact decimal expressions. For example, when the divisor N is 15, the VCO frequency is a repeating fraction, 0.06666..., times the reference signal frequency.

The present invention provides an apparatus and method for generating a digitally programmable, continuous wave signal with low phase noise and low spurious sidebands, regularly spaced programmed frequencies, and quick switching times between the programmed frequencies. The invention can also generate continuous wave signals at programmed frequencies having exact decimal values.

According to the invention, a synthesizer for generating a programmable frequency, continuous wave signal comprises a digital rate multiplier and digital divider interposed in a reference signal path to a phase locked loop (PLL) circuit. The rate multiplier and divider operate to program a reference frequency for the PLL circuit which is related to a known frequency (the "source frequency") of a source reference signal by a ratio of a programmable integer number N to the product of two predetermined divisors (those of the rate multiplier and divider, respectively). Accordingly, the predetermined divisors and source frequency are parameters that define a set of frequencies, each separated by a uniform step size, from which the reference frequency of the PLL circuit can be selected by an appropriate choice of the number N.

According to one aspect of the invention, the divider operates to facilitate locking by the PLL circuit. The rate multiplier programs the reference frequency for the PLL circuit by selectively suppressing pulses of the reference signal according to the programmed value N. As a result, adjacent pulses of the reference signal at the rate multiplier's output may have a peak-to-peak phase deviation of a full cycle or 360 degrees. When dividing the frequency of the reference signal by its divisor, the divider also operates to reduce the phase deviation of the reference signal. By limiting the phase deviation of the reference signal, the PLL circuit is able to lock its output signal to the reference frequency.

According to a further aspect of the invention, a spur filter is interposed between a phase detector and VCO oscillator of the PLL circuit to reduce spurious FM sidebands in the continuous wave signal. The spurious FM sidebands are the result of AC components which are introduced into the phase detector output by the rate multiplier and divider. The AC components occur at frequencies ("spur frequencies") that are integer multiples of the reference frequency step size. In one embodiment of the invention, the spur filter is a pole zero low pass filter with one or more zeros located at such spur frequencies to attenuate the AC components. In another embodiment of the invention, the spur filter is an all zeros filter to further increase the PLL circuit bandwidth.

One advantage of the PLL synthesizer according to the invention is that the noise gain of the PLL circuit is unity, for phase noise. Thus, the phase noise of the reference signal and of the phase detector are not amplified by the PLL circuit, minimizing the phase noise of the synthesized continuous wave signal. A further advantage is that the PLL synthesizer can be designed with a desired frequency step size by appropriately selecting the source frequency, and divisor values of the rate multiplier and divider.

According to yet another aspect of the invention, one or more mixers are interposed in the feedback path of the PLL circuit to shift or extend the set of frequencies that can be generated by the PLL synthesizer.

Additional features and advantages of the invention will be made apparent from the following detailed description of a preferred embodiment which proceeds with reference to the accompanying drawings.

## BRIEF DESCRIPTION OF THE DRAWINGS

Fig. 1 is a block diagram of a PLL synthesizer according to a first embodiment of the invention;

Fig. 2 is a block diagram of a 8-bit binary rate multiplier and digital divider in the PLL synthesizer of Fig. 1;

Fig. 3 is a schematic diagram of logic gates in the rate multiplier of Fig. 2;

Fig. 4 is a waveform diagram of showing signals generated by a 4-bit rate multiplier;

Fig. 5 is a schematic diagram of a pole-zero low pass filter having one zero for use as a spur filter in the PLL synthesizer of Fig. 1;

Fig. 6 is a graph of the frequency and phase response of the filter of Fig. 5;

Fig. 7 is a schematic diagram of a second pole-zero low pass filter having two zeros useable as the spur filter in the PLL synthesizer of Fig. 1;

Fig. 8 is a graph of the frequency and phase response of the filter of Fig. 7;

Fig. 9 is a schematic diagram of an all zero filter also useable as the spur filter in the PLL synthesizer of Fig. 1;

Fig. 10 is a block diagram of a PLL synthesizer according to a second embodiment of the invention; and

Fig. 11 is a block diagram of a PLL synthesizer according to a third embodiment of the invention.

## DETAILED DESCRIPTION OF THE PREFERRED EMBODIMENTS

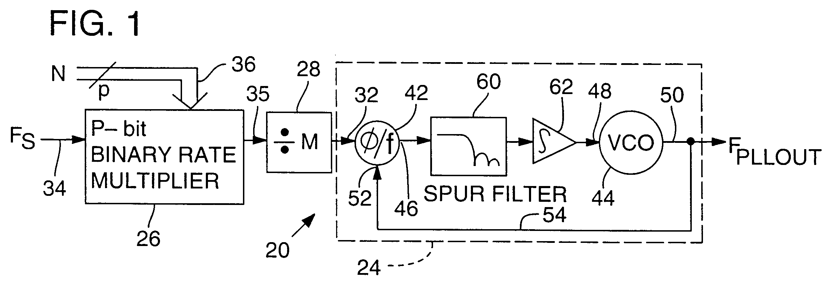

With reference to Fig. 1, a phase locked loop (PLL) synthesizer 20 according to a first embodiment of the invention comprises a PLL circuit 24, a rate multiplier 26, and a divider 28. The rate multiplier 26 and the divider 28 are interposed in a path (the "reference signal path") of a reference signal from a reference signal source (shown as $F_s$) to a reference signal input 32 of the PLL circuit 24. At the source, the reference signal has a constant, predetermined frequency (the "source frequency"), such as 600 MHz. The frequency of the reference signal at the PLL circuit input 32 is modified by the operation of the rate multiplier 26 and the divider 28, and is user programmable (i.e. selectable).

The rate multiplier 26 is preferably a p-bit binary rate multiplier which has an input 34 for receiving the reference signal, and an input 36 for receiving a p-bit binary number N. The p-bit binary rate multiplier operates to selectively suppress pulses of the reference signal so as to reduce the frequency of the reference signal at its output 35 according to the following relation:

$$F_{RMOUT} = F_S \left( \frac{N}{2^P} \right) \qquad\qquad (1)$$

where $F_s$ is the source frequency at the rate multiplier input 34, and $F_{RMOUT}$ is the reference signal frequency at the rate multiplier output 35.

The divider 28 is connected to the output of the rate multiplier 26 and operates to further reduce the reference signal frequency by a fixed ratio of one to a divisor, M. The divider 28 is preferably a synchronous digital divider, and can be implemented with series connected flip-flop circuits. For example, a divider with a divisor M equal to 4 can be implemented with two flip-flop circuits in series. Preferably, the divisor M is chosen such that the fraction 1/M has a terminating decimal expression. More specifically, choosing M such that:

$$M = 2^K \cdot 5^L \qquad\qquad (2)$$

where K and L are non-negative integers, results in the fraction 1/M having such a terminating decimal expression.

Together, the rate multiplier 26 and divider 28 operate to reduce the reference signal frequency by the following relation:

$$F_{PLLIN} = F_S \left( \frac{N}{2^P \cdot M} \right) \qquad\qquad (3)$$

where $F_s$ is the source frequency, and $F_{PLLIN}$ is the reference signal frequency at the PLL circuit input 32. The digital number N can be user programmed to equal any integer value between 1 and $2^P - 1$. Accordingly, the reference signal frequency at the PLL circuit input 32 can be set by the user to any one of a set of programmable frequencies spaced at regular intervals (the "step size") equal to the source frequency divided by the product, $2^P$ times M. For example, with a 512 MHz source frequency, 7-bit rate multiplier, and divide-by-four divider, the step size is 1 MHz. In another example, with a 600 MHz source frequency, p equals 7 and M equals 4, the step size is 1.171875 MHz (a terminating decimal quantity). With an appropriate choice of the divisor M and source frequency, the programmable reference frequencies can be designed to have exact decimal number expressions.

The PLL circuit 24, in the first embodiment of the invention, comprises a phase detector 42 and a variable frequency oscillator 44. The phase detector 42 has an output 46 coupled to an input 48 of the variable frequency oscillator 44. The oscillator 44, in turn, has an output 50 connected to an input 52 of the phase detector 42 to form a feedback loop 54.

The oscillator 44 is preferably a voltage controlled oscillator. At the output 50, the oscillator 44 produces a signal (the "synthesized signal") whose frequency varies relative to a signal at the oscillator input 48. The phase detector 42 is preferably a digital or phase/frequency phase detector, such as the phase detector MCK12140 manufactured by Motorola. The phase detector produces a phase error signal at its output 46 which is related to a phase difference between the reference signal at the PLL input 32 and the synthesized signal at the phase detector input 52. With the phase error signal, the phase detector 42 continuously adjusts the oscillator's synthesized signal frequency to "lock" or servo the phase of the synthesized signal to that of the reference signal at the PLL input 32. When the synthesized signal is properly locked to the reference signal, the synthesized signal is a continuous wave signal.

The PLL circuit 24 further comprises a spur filter 60 and an integrator 62 which are connected in series between the phase detector output 46 and oscillator input 48. The spur filter 60 acts to attenuate spurious sidebands in the synthesized signal as explained further below. The integrator 62 integrates the phase error signal for proper feedback control of the synthesized signal's phase and frequency.

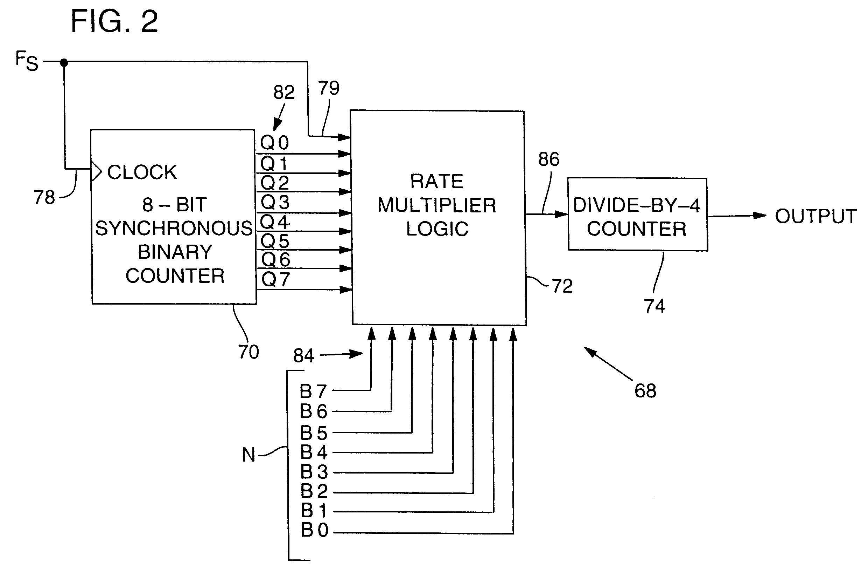

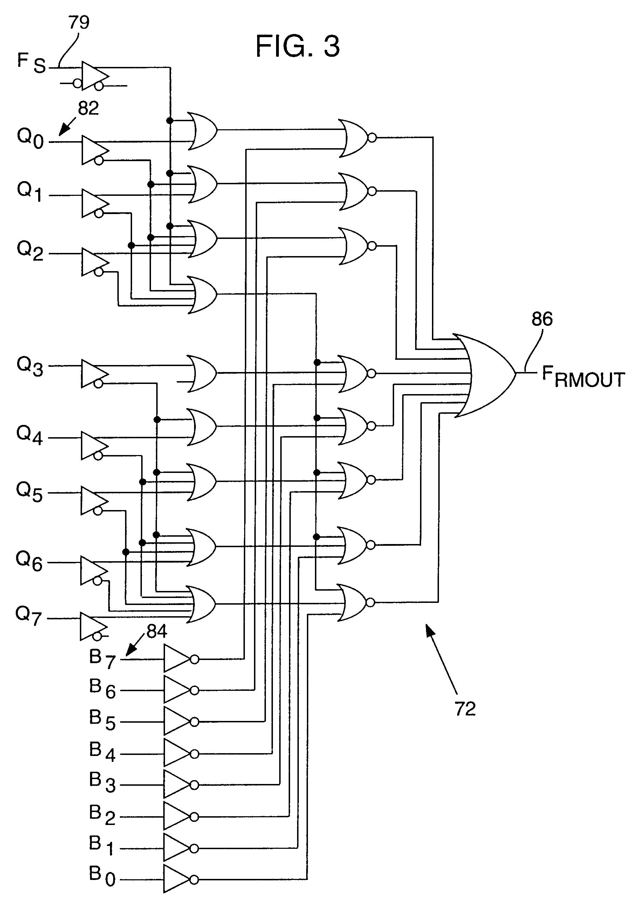

Referring now to Figs. 2 and 3, the rate multiplier 26 (Fig. 1) and divider 28 (Fig. 1) preferably are implemented in a single monolithic integrated circuit (IC) 68 which comprises an p-bit synchronous binary counter 70, a rate multiplier logic 72, and a divide-by-M counter 74. An example is the semi-custom IC, part number SC64029FN, manufactured for Hewlett-Packard by Motorola. The SC64029FN is implemented in ECL logic, and is capable of operation at clock frequencies up to 800 MHz. In the SC64029FN semi-custom IC and in the example shown in Fig. 2, p is 8, and M equals 4. The binary counter 70 and logic 72 form the rate multiplier 26, while the divider 28 is realized as the divide-by-four counter 74.

The binary counter 70 and rate multiplier logic 72 are clocked by the source reference signal ($F_s$) at inputs 78 and 79, respectively. In response, the binary counter 70 forms an 8-bit binary count of the pulses of the source reference signal at outputs 82 (Q0-Q7). The source reference signal and binary count bits are combined in the rate multiplier logic 72 according to a number of gating functions. The rate multiplier logic 72 combines selected of the gating functions according to the programmed binary number N received at inputs 84 (B0-B7). This produces the reference signal at an output 86 of the rate multiplier logic 72 which is $N/2^p$ times the source reference frequency.

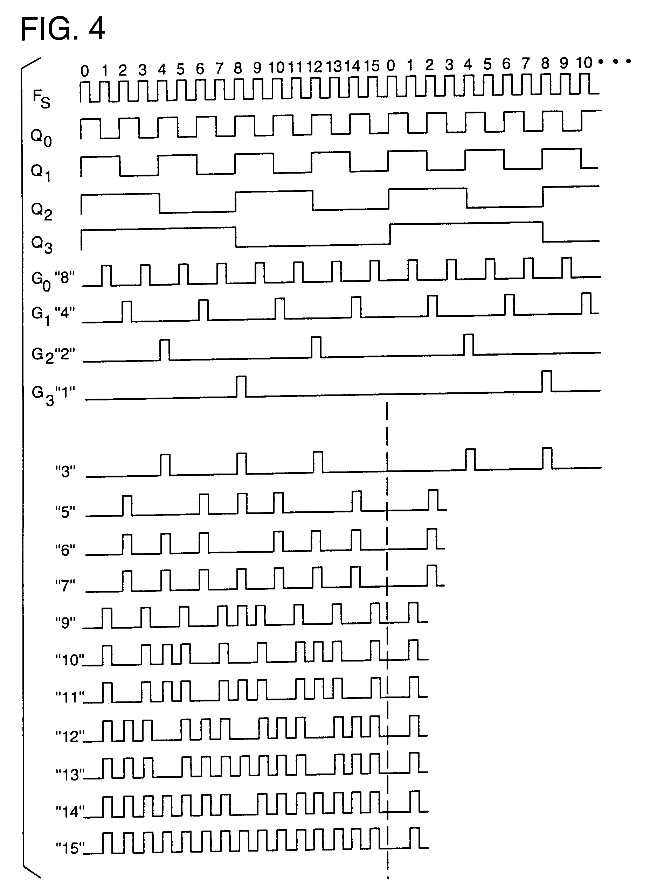

With reference to Fig.4, the gating functions are, in general, an AND combination of the source reference signal and one or more binary count bits, with the most significant binary count bit inverted. The first gating function is an AND combination of the source reference signal and the inverted least significant binary count bit, Q0. Each succeeding gating function adds the next more significant binary count bit, with that bit being inverted, and the preceding bits not inverted. In a 4-bit rate multiplier (i.e., p = 4) for example, the gating functions are as follows:

$$G_0 = F_S \wedge \overline{Q}_0 \tag{4}$$
$$G_1 = F_S \wedge Q_0 \wedge \overline{Q}_1 \tag{5}$$
$$G_2 = F_S \wedge Q_0 \wedge Q_1 \wedge \overline{Q}_2 \tag{6}$$
$$G_3 = F_S \wedge Q_0 \wedge Q_1 \wedge Q_2 \wedge \overline{Q}_3 \tag{7}$$

where $F_s$ represents the source reference signal; $G_0$ - $G_3$, the gating functions; and $Q_0$ - $Q_3$, the binary count bits.

In general, the gating functions can be expressed as follows:

$$G_K = F_S \wedge Q_1 \wedge Q_2 \wedge ... \wedge Q_{K-1} \wedge \overline{Q}_K \tag{8}$$

The result of these gating functions are signals which have pulses at a frequency which is half the frequency of the preceding gating function. For example, the gating function $G_0$ produces a signal with pulses at half the frequency of the source reference signal, $F_S$. The gating function $G_1$'s pulses are at half again the frequency of gating function $G_0$'s pulses, and so forth. The waveforms for the signals $F_S$, $Q_0$ - $Q_4$, and $G_0$ - $G_3$ are shown in Fig. 4.

The reference signal at the rate multiplier output is formed by making an appropriate OR combination of one or more gating function signals according to the programmed number N such that equation (1) given above obtains. For example, for values of N equal to 1, 2, 4, and 8, the output reference signal is formed from a single one of the gating function signals, respectively $G_3$, $G_2$, $G_1$, and $G_0$. For N equal to 3, an OR combination of gating functions $G_2$ and $G_3$ forms an output reference signal at the proper frequency, as follows:

$$F_{RMOUT} = G_2 \vee G_3 \tag{9}$$

An appropriate OR combination of from one to all of the gating function signals can be made for each N from 1 to 15 (i.e., $2^p$ - 1). The signals resulting from each such OR combinations are labelled by the value of N in quotes in Fig. 4.

Referring again to Fig. 3, the rate multiplier logic 72 to produce gating functions and OR combinations for an 8-bit rate mutliplier is realized with OR, NOR, and inverter logic gates.

Referring again to Figs. 1, 2 and 4, the OR combination of the gating functions effected by the rate multiplier 26 (Fig. 1) generally operates to suppress some pulses of the source reference signal. As a result, the signal at the rate multiplier output 86 will have a peak-to-peak phase deviation approaching 360 degrees for some values of N. At high frequencies, such a large phase deviation can exceed a PLL circuit's dynamic range, preventing phase lock.

The divider 28 (Fig. 1), by further dividing the reference signal at the rate multiplier output, also operates to reduce the phase deviation caused by the rate multiplier 26. For example, with the divisor M equal to 4 as in counter 74 (Fig. 2), the phase deviation does not exceed 200 degrees. This smaller phase deviation generally is tolerated by PLL circuits. Accordingly, the combination of the rate multiplier 26 and divider 28 produces a reference signal at a programmable frequency which is useable with the PLL circuit 24.

Referring again to Fig. 1, the phase detector 42 in the first embodiment generates a phase error signal having a voltage proportional to the phase difference between the reference frequency signal at the PLL input 32 and the synthesized signal at the phase detector input 52. When the phases of the signals are locked by the PLL circuit 24, the phase error signal contains AC sinusoidal components at frequencies ("spur frequencies") equal to integer multiples of the step size (due to the phase deviation introduced by the rate multiplier). The largest amplitude AC component occurs at a spur frequency equal to M times the step size. For example, with a 512 MHz source reference frequency, p = 7, and M = 4, the spur frequencies of the AC components are at multiples of 1 MHz (the step size), with the largest such component at 4 MHz. If not filtered, the AC phase error signal components cause spurious FM sidebands in the synthesized signal. Accordingly, the AC components are preferably attenuated by the spur filter 60.

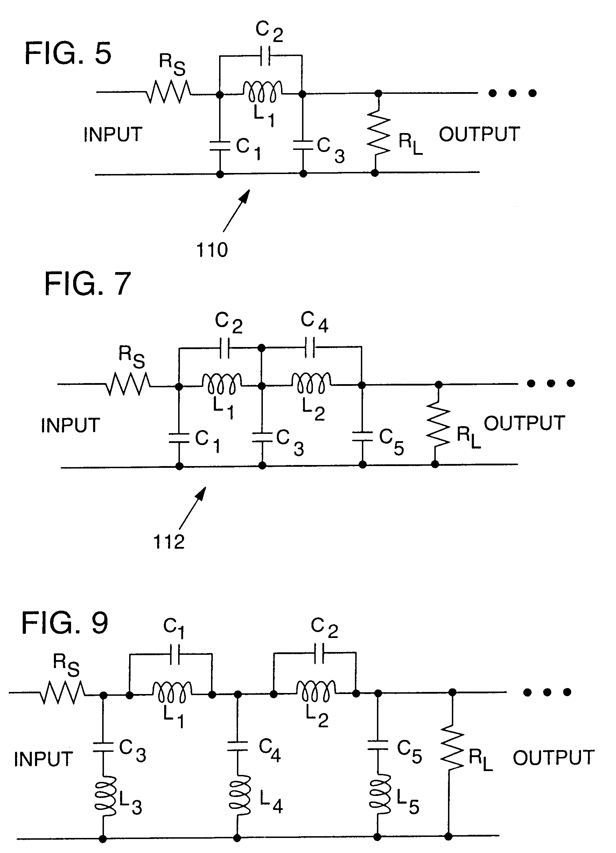

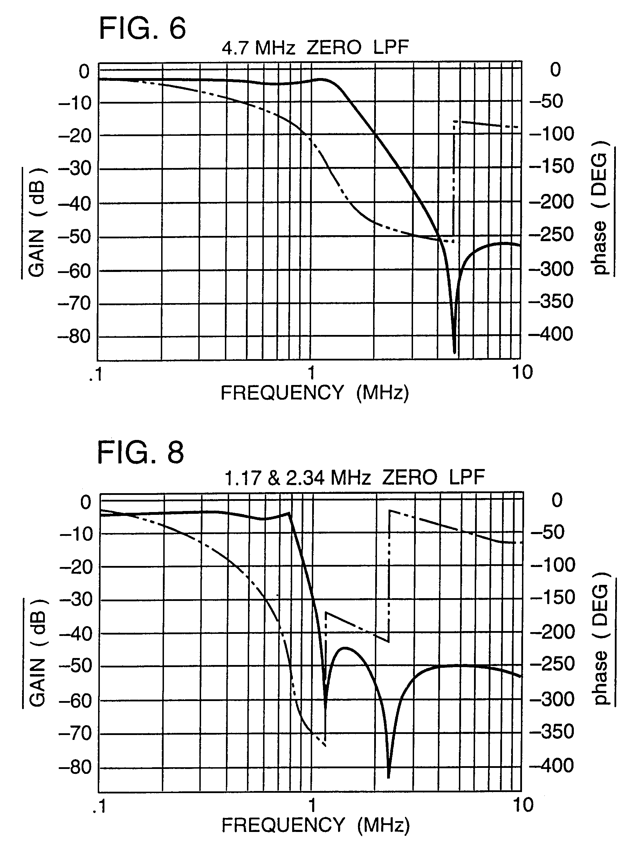

With reference to Figs. 5-8, the spur filter 60 (Fig. 1) preferably is implemented as a pole-zero low pass filter 110, 112 having one or more zeros located at these spur frequencies. The pole zero low pass filter 110 (Fig. 5) has a single zero which is at 4.7 MHz as shown in the graph of Fig. 6 when the component values are as listed in the following Table I.

Table I

| 4.7 MHz Zero Low Pass Filter. | | |
|---|---|---|
| Component | | Value |
| C1 | Capacitor | 1.5 nF |
| L1 | Inductor | 15 $\mu$H |
| C2 | Capacitor | 75 pF |
| C3 | Capacitor | 2.2 nF |

The pole-zero low pass filter 112 (Fig. 7) has a pole, P, and two zeros, $Z_1$ and $Z_2$, given by the following equations:

$$P \approx \frac{1}{2\pi (R_S \| R_L) (C_1 + C_3 + C_5)} \qquad (10)$$

$$Z_1 = \frac{1}{2\pi \sqrt{L_1 C_2}} \qquad (11)$$

$$Z_2 = \frac{1}{2\pi \sqrt{L_2 C_4}} \qquad (12)$$

With the component values listed in the following Table II, the filter 112 has zeros at 1.17 and 2.34 MHz as shown in the graph of Fig. 8.

Table II

| 1.17 & 2.34 MHz Zeros Low Pass Filter. | | |
|---|---|---|
| Component | | Value |
| C1 | Capacitor | 200 pF |
| L1 | Inductor | 27 μH |
| C2 | Capacitor | 170 pF |
| C3 | Capacitor | 2.2 nF |
| L2 | Inductor | 27 μH |
| C4 | Capacitor | 680 pF |
| C5 | Capacitor | 2.2 nF |

Referring again to Fig. 1, when such pole-zero low pass filters 110, 112 are used for the spur filter 60, the unity gain bandwidth of the PLL circuit 24 can be no greater than approximately 1/10 of the frequency step size. Otherwise, the PLL circuit's phase margin will be insufficient, due to the phase lag of the spur filter.

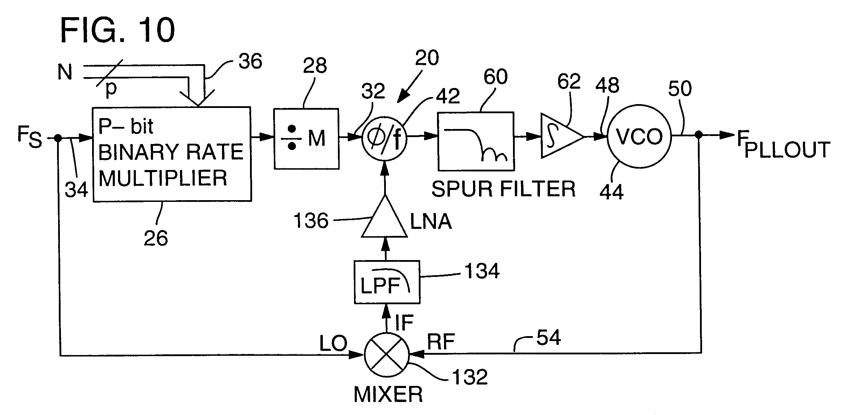

Referring to Fig. 9, an all zero filter 114 also can be used as the spur filter 60 (Fig. 1). The illustrated all zero filter 114 has two zeros at frequencies given by equations (8) and (9) above, with $L_3C_3 = L_1C_1$, $L_4C_4 = L_1C_1$ or $L_2C_2$, and $L_5C_5 = L_2C_2$. All zero filters can have less phase lag than the previously described pole zero filters. Thus, they allow a higher PLL circuit bandwidth of up to 20% of the frequency step size, but are more complex.

Referring now to Fig. 10, in a second embodiment of the invention, a mixer 132 and a low pass filter 134 are interposed in the feedback path 54 of the PLL synthesizer 20 (of Fig. 1). A low noise amplifier 136 can also be connected following the low pass filter 134. In the illustrated embodiment, the mixer 132 heterodynes the synthesized signal with the source reference signal. This serves to shift the set of programmable frequencies of the PLL synthesizer by the source reference frequency, while maintaining the same step size. More specifically, with the mixer 132, the PLL synthesizer produces a synthesized signal at programmed frequencies given by the following equation:

$$F_{PLLOUT} = F_s \left( 1 \pm \frac{N}{2^P \cdot M} \right) \tag{13}$$

For example, if $F_s = 600MHz$, $p = 7$, and $M = 4$, then $F_{PLLOUT}$ could be programmed from 450 MHz to approximately 590 MHz in steps of 1.171875 MHz.

Alternatively, the PLL synthesizer's programmable frequencies can be shifted to any other desired range by mixing the synthesized signal with another signal having an appropriate frequency. As long as the signal that is mixed with the synthesized signal has a frequency which is an integer multiple of the frequency step size (the source reference signal has this property), any spurious frequencies introduced by the mixer also occur at integer multiples of the step size and will be attenuated by the spur filter 60. Thus, the mixer 132 operates to up-convert the PLL synthesizer's programmable frequency range to a higher frequency range without adding phase noise or spurs at frequencies not already present due to the rate multiplier 26.

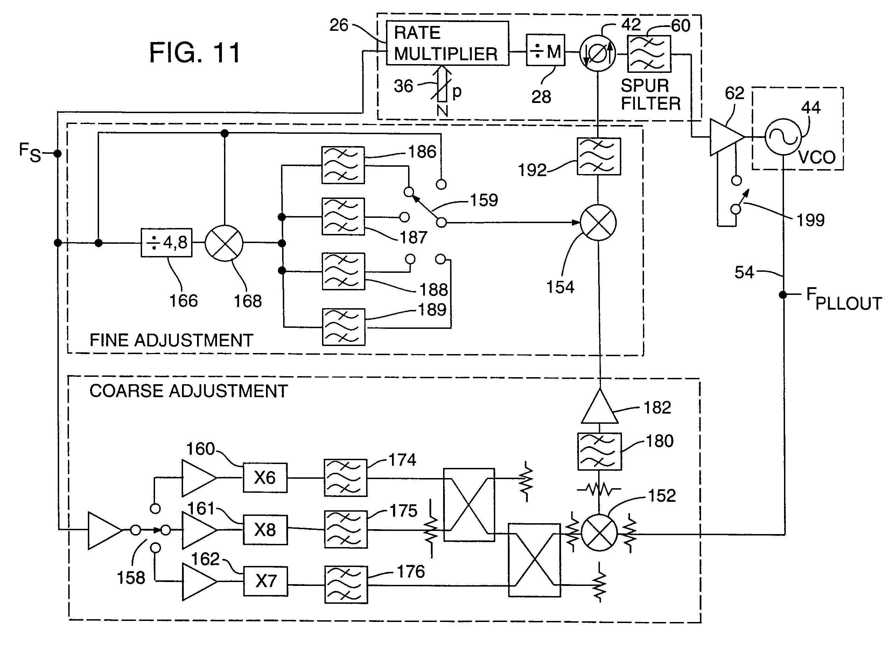

With reference to Fig. 11, according to a third embodiment of the invention, plural mixers 152, 154 are interposed in the feedback path 54 of the PLL synthesizer 20 (of Fig. 1). Further, means in the form of switches 158, 159, multipliers 160-162, a divider 166, and a mixer 168 are provided for generating signals of various frequencies at integer multiples of the step size and for selecting desired frequencies for mixing with the synthesized signal in the mixers 152, 154. By selecting from multiple signal frequencies to mix with the synthesized signal in the feedback loop, the PLL synthesizer's programmable frequency range can be both shifted and extended.

The switch 158 selects one of three coarse adjustment signals generated by the multipliers 160-162. The multipliers 160-162 generate the coarse adjustment signals by multiplying the frequency of the source reference signal by fixed factors, six, eight, and seven, respectively. For example, with a source frequency of 600 MHz, the multipliers generate coarse adjustment signals having three frequencies of 3600 MHz, 4800 MHz, and 4200 MHz, respectively. Noise which may be introduced into the coarse adjustment signals are reduced by a set of three filters 174-176. The mixer 152 heterodynes the coarse adjustment signal selected by the switch 158 with the synthesized signal in the feedback path 54. A filter 180 and an amplifier 182 are connected in the feedback path 54 following the mixer 152 to reduce noise and spurious in the mixer output.

The switch 159 selects one of four fine adjustment signals generated by the divider 166 and the mixer 168. The divider 166, clocked by the source reference signal, generates signals that are 1/4 and 1/8 of the source frequency. These signals at 1/4 and 1/8 of the source frequency are then mixed by the mixer 168 with the source reference signal to form the four fine adjustment signals. With a source frequency of 600 MHz, the four fine adjustment signals have frequencies of 450 MHz, 525 MHz, 575 MHz, and 750 MHz. A set of four filters 186-189 reduce noise and spurious in the fine adjustment signals. The mixer 154 heterodynes the fine adjustment signal selected by the switch 159 with the synthesized signal in the feedback path 54. A filter 192 in the feedback path following the mixer 154 reduces noise and spurious in the synthesized signal at the mixer output. Switch 199 provides for sign control of PLL amplifier 62.

By mixing the synthesized signal with coarse and fine adjustment signals in the mixers 152, 154, the set of synthesized signal frequencies, which can be programmed by selecting the digital value N of the rate multiplier, is shifted to a higher frequency range. By selecting which of the various coarse and fine adjustment signals are mixed with the synthesized signal and providing for sign control of PLL amplifier 62, the set of programmable frequencies can be shifted to a desired one of several contiguous higher frequency ranges. Accordingly, by mixing the synthesized signal in the feedback path with a selected one of plural adjustment frequencies, the set of programmable frequencies also is extended to a much broader frequency range. For example, in the illustrated system with a source frequency of 600 MHz, p = 7, and M = 4, the programmable frequency range may be approximately 76-150 KHz in steps of 1.171875 MHz, if no adjustment signals are mixed with the synthesized signal. With selecting and mixing of adjustment signals as illustrated in Fig. 11 and described above, the programmable frequency range can be extended to a higher frequency range of from approximately 2700 to 5700 MHz, also in steps of 1.171875 MHz.

A further advantage is obtained in the third embodiment when the adjustment signals have frequencies which are integer multiples of the step size. As explained above in connection with the second embodiment, as long as the signal being mixed with the synthesized signal has a frequency which is an integer multiple of the step size, any spurious noise introduced by the mixer also occur at integer multiples of the step size. Such spurious noise will be attenuated by the spur filter 60. Accordingly, when all the adjustment signal frequencies are at multiples of the step size, the programmable frequency range is extended to a higher frequency range while maintaining low spurious side bands.

Because the adjustment signals are all directly synthesized from a common low noise source (i.e. the 600 MHz reference), extremely low phase noise is preserved over the entire shifted and extended output frequency range.

Having described and illustrated the principles of our invention with reference to a preferred embodiment, it will be recognized that the invention can be modified in arrangement and detail without departing from such principles. In view of the many possible embodiments to which the principles of our invention may be put, it should be recognized that the detailed embodiments are illustrative only and should not be taken as limiting the scope of our invention. Rather, we claim as our invention all such embodiments as may come within the scope and spirit of the following claims and equivalents thereto.

**Claims**

1. A variable frequency signal synthesizer (20), comprising:

a rate multiplier (26) having inputs (34, 36) for receiving a reference signal and a digital value, the reference signal having a source frequency at the rate multiplier input, the rate multiplier reducing the reference signal frequency at an output (35) of the rate mutliplier by a ratio of the digital value to a first integer number;

a divider (28) having an input connected to the rate multiplier output, the divider further reducing the reference signal frequency at an output of the divider by a ratio of one to a second integer number; and

a phase locked loop (24) having an input (32) connected to the divider output for receiving the reference signal, the phase locked loop producing a synthesized signal at an output (50), the synthesized signal having a phase locked to that of the reference signal at the phase locked loop input and a frequency related to the source frequency by a ratio of the digital value to the product of the first and second integer numbers.

2. The synthesizer of claim 1 wherein the phase locked loop (20) comprises:

a phase detector (42) having a reference input (32) coupled to the divider output for receiving the reference signal and a feedback input (52) coupled to the phase locked loop output (50) for receiving the synthesized signal, the phase detector producing a phase error signal having a DC voltage related to a phase difference between the reference signal and the synthesized signal; and

a spur filter (60) for passing the DC voltage of the phase error signal while blocking AC components of the phase error signal.

3. The synthesizer of claim 2 wherein the phase locked loop (20) further comprises:

a mixer (132, 152, 154) connected to the feedback input (52) of the phase detector (42) for mixing the synthesized signal with an adjustment signal whereby the synthesized signal at the phase locked loop output (50) is shifted in frequency from the reference signal frequency at the reference input (32) of the phase detector.

4. The synthesizer of claim 3 further comprising:

means (158, 159, 160-162, 166, 168) for selecting a frequency of the adjustment signal.

5. A method for generating a digitally programmable, variable frequency signal, comprising:

generating a reference signal having a predetermined frequency;

continuously generating a p-bit binary count of the pulses of the reference signal;

performing a set of gating functions of the reference signal and the binary count, each gating function being an AND combination of the reference signal and one or more bits of the binary count in which the most significant binary count bit in the combination is inverted;

combining selected of the gating functions to produce a rate multiplied signal having a selectable number N of pulses for each $2^p$ pulses of the reference signal;

generating a divided rate multiplied signal having a pulse for each of a predetermined number M of pulses of the rate multiplied signal;

generating a variable frequency signal; and

locking the phase of the variable frequency signal to the phase of the divided rate multiplied signal.

6. The method of claim 5 further comprising:

selecting the number N whereby the frequency of the variable frequency signal is related to the frequency of the reference signal by a ratio of N to the product of $2^p$ and M.

7. The method of claim 6 wherein the frequency of the variable frequency signal is related to the frequency of the reference signal by the relation:

$$F_{variable} = F_{reference} \left( \frac{N}{2^p \cdot M} \right)$$

where $F_{variable}$ is the frequency of the variable frequency signal and $F_{reference}$ is the frequency of the reference signal.

8. The method of claim 5 further comprising:

generating a phase error signal having a voltage related to a phase difference between the variable frequency signal and the reference signal;

filtering AC components of the phase error signal; and

controlling the frequency of the variable frequency signal responsive to the phase error signal.

9. The method of claim 5 further comprising:

heterodyning the variable frequency signal and an adjustment signal;

generating a phase error signal having a voltage related to a phase difference between the heterodyned variable frequency signal and the reference signal;

filtering AC components of the phase error signal; and

controlling the frequency of the variable frequency signal responsive to the phase error signal.

**10.** The method of claim 9 further comprising:

selecting a frequency of the adjustment signal from a plurality of frequencies.

FIG. 1

# FIG. 2

EP 0 665 651 A2

# FIG. 3

# FIG. 4

FIG. 5

FIG. 7

FIG. 9

# FIG. 6

4.7 MHz ZERO LPF

# FIG. 8

1.17 & 2.34 MHz ZERO LPF

# FIG. 10

# FIG. 11

EP 0 665 651 A2